# EUROPEAN PATENT SPECIFICATION

(11) **EP 3 040 971 B1**
(45) Date of publication and mention of the grant of the patent: **23.08.2017**
(21) Application number: 15202782.7
(22) Date of filing: 28.12.2015
(51) Int. Cl.: G09G 3/32

(54) **OLED DISPLAY DEVICE**
OLED-ANZEIGEVORRICHTUNG
DISPOSITIF D'AFFICHAGE OLED

(30) Priority: 31.12.2014 KR 20140195605
(43) Date of publication of application: 06.07.2016
(73) Proprietor: LG Display Co., Ltd., Seoul 07336 (KR)
(72) Inventor: MIWA, Koichi, 413-811 Gyeonggi-do (KR); HAN, Seong-Eok, 576-952 Jeollabuk-do (KR); LEE, Jungyun, 413-810 Gyeonggi-do (KR); JO, Yonghan, 130-081 Seoul (KR)
(74) Representative: Ter Meer Steinmeister & Partner

(56) References cited:
- EP-A1- 1 873 745
- EP-A1- 2 747 066
- US-A1- 2010 079 423
- US-A1- 2014 176 625

## Description

### CROSS REFERENCE TO RELATED APPLICATION

This application claims priority from and the benefit under 35 U.S.C. §119(a) of Korean Patent Application Number 10-2014-0195605 filed on December 31, 2014.

### BACKGROUND OF THE INVENTION

### Field of the Invention

The present invention relates to an organic light-emitting diode (OLED) display device that displays images and to a method for driving or operating the same.

### Description of Related Art

Organic light-emitting diode (OLED) display devices have recently been prominent as next generation display devices. Such OLED display devices have some advantages, such as relatively fast response speeds, high contrast ratios, high light emitting efficiency, high luminance levels, and wide viewing angles, since OLEDs able to emit light by themselves are used therein.

Such an OLED display device includes subpixels arranged in the shape of a matrix, each of the subpixels including an OLED, and controls the brightness of selected pixels based on scanning signals. Each of the subpixels of the OLED display device also includes a driving circuit driving the OLED. The OLED driving circuit in each of the subpixels includes a transistor, a storage capacitor, and the like. The transistor of the driving circuit has unique characteristics, such as a threshold voltage, mobility, and the like.

The transistor of the driving circuit (in particular, a driving transistor supplying a current to an OLED) degrades along with the lapse of driving period, whereby the characteristics thereof may change. Thus, the characteristics of one driving transistor may have a difference from those of another driving transistor. Such differences in the characteristics between the driving transistors may be a main reason why subpixels have differences in the degrees of luminance, thereby degrading image quality. Therefore, functions able to sense and compensate for the characteristics of the transistors within individual subpixels have been developed.

In order to sense and compensate for the unique characteristics of a transistor within each of the subpixels, such as a threshold voltage, a saturated voltage of a specific sensing node is sensed (measured) by initializing a specific sensing node of the subpixel to a specific voltage value and subsequently changing the voltage value, and the characteristics of the transistor, such as the threshold voltage, are compensated based on the sensed voltage.

However, this approach of compensating the unique characteristics of a transistor, such as a threshold voltage, does not reflect changes in the unique characteristics of the transistor, such as the threshold voltage. In addition, this approach fails to completely compensate for the unique characteristics, such as the threshold voltage, since a sensor and a compensation circuit of an OLED display device have different resolutions. Consequently, stains may occur on the screen having low-grayscale luminance.
US 2014/0176625 A1 discloses an organic light emitting diode (OLED) display device and a method of driving the same, by which a voltage margin for compensating for characteristic deviation is ensured by a data driver, thereby improving reliability and image quality. The data driver is used for sensing a threshold voltage and mobility of the driving TFT using a sensing line connected to each pixel in a measurement mode, and applying a data voltage to data lines connected to each pixel in a display mode. Furthermore a timing controller for sorting image data input from an external source and supplying the image data to the data driver in the display mode is disclosed.

### BRIEF SUMMARY OF THE INVENTION

The object of the present invention is solved by the features of the independent claims.

Various aspects provide an organic light-emitting diode (OLED) display device able to repeat the operation of sensing and compensating for an updated threshold voltage of a subpixel, and after the lapse of time, correct differences in the threshold voltage between the driving transistors based on changes in the threshold voltage of the driving transistors in order to reduce or remove the differences in the luminance between the subpixels, thereby further improving image quality.

Also provided is an OLED display device able to sense a threshold voltage and changes in the threshold voltage in more precise units in the operation of sensing an initial threshold voltage and an updated threshold voltage in order to more completely compensate for the threshold voltage, thereby removing stains on the screen having low-grayscale luminance.

An OLED display device includes: an OLED display panel on which subpixels are disposed; a gamma reference voltage supply circuit supplying gamma reference voltages that are variable during driving operation and during sensing operation for sensing a threshold voltage; a data driver supplying data voltages based on the gamma reference voltages to data lines, wherein the data driver senses a voltage of a sensing node within each of the subpixels in sensing operation; and a timing controller controlling the data driver, wherein the timing controller performs a compensation process based on the voltage sensed by the data driver, wherein the gamma reference voltage supply circuit may supply gamma reference voltages having a first voltage range during driving operation and a second voltage range during sensing operation for sensing a threshold voltage of the sensing node, wherein the first voltage range is greater than the second voltage range.

Preferably, the gamma reference voltage supply circuit may supply the gamma reference voltages within a predetermined gamma reference voltage range between a minimum gamma reference voltage and a maximum gamma reference voltage and may vary at least one of the minimum gamma reference voltage and the maximum gamma reference voltage, thereby varying the gamma reference voltages.

Preferably, the data driver may include a digital-to-analog converter supplying data voltages based on the gamma reference voltages within the predetermined gamma reference voltage range to the data lines.

Preferably, the data driver may comprise an analog-to-digital converter sensing a voltage of a sensing node within each of the subpixels, preferably in the sensing mode.

Preferably, the digital-to-analog converter may supply the data voltages based on the gamma reference voltages in the predetermined gamma reference voltage range, and may supply data voltages based on the gamma reference voltages in a range narrower than the predetermined gamma reference voltage range to the data lines when the threshold voltage is updated.

Preferably, the analog-to-digital converter may sense a threshold voltage of a driving transistor of each of the subpixels when sensing the initial threshold voltage.

Preferably, the analog-to-digital converter may sense a change in the threshold voltage of the driving transistor of each of the subpixels when the threshold voltage is updated.

Preferably, the OLED device may further comprise a memory for storing threshold voltage and/or updated threshold voltages of the driving transistor.

Preferably, the timing controller may save the threshold voltage of the driving transistor of each of the subpixels sensed by the analog-to-digital converter in the memory when sensing the initial threshold voltage,

Preferably, the timing controller may supply compensated data based on the threshold voltage to the data driver during driving.

Preferably, the timing controller may save the change in the threshold voltage of the driving transistor of each of the subpixels sensed by the analog-to-digital converter ADC) in the memory when sensing the initial threshold voltage,

Preferably, the timing controller may supply compensated data based on the threshold voltage and the change in the threshold voltage during driving.

Preferably, the timing controller may save the threshold voltage and the change in the threshold voltage sensed by the analog-to-digital converter in the memory as a voltage per bit higher than a voltage per unit bit sensed by the analog-to-digital converter.

Preferably, the maximum gamma reference voltage when sensing the updated threshold voltage is lower than the maximum gamma reference voltage during the threshold voltage sensing operation and/or the driving operation.

Preferably, the minimum gamma reference voltage when sensing the updated threshold voltage is higher than the minimum gamma reference voltage during the threshold voltage sensing operation and/or the driving operation.

Preferably, each of the subpixels comprises an organic light-emitting diode, a driving transistor comprising a first node to which the data voltages are applied, a second node connected to a first electrode of the organic light-emitting diode, and a third node electrically connected to a driving voltage line; a first transistor electrically connected between a corresponding data line of the data lines through which the data voltages are supplied and the first node of the driving transistor; a second transistor electrically connected between a reference voltage line through which a reference voltage is supplied and a second node of the driving transistor; and a capacitor electrically connected between the first node and the second node of the driving transistor.

Preferably, the OLED device may further comprise a power controller coupled to the data driver, wherein the gamma reference voltage supply circuit may be included in the power controller or in the data driver.

A method for operating an organic light-emitting diode display device may comprise the steps of: providing a first range of gamma reference voltages during driving the OLED display device; providing a second range of gamma reference voltages during sensing a threshold voltage during a sensing mode; supplying data voltages based on the first or second gamma voltage range to data lines, sensing a voltage of a sensing node within each of the subpixels in sensing mode; compensating data voltages to be supplied to the OLED display panel based on the sensed voltage.

The DAC may supply the data voltages based on the gamma reference voltages within the predetermined gamma reference voltage range to the data lines during normal driving.

According to the present invention as set forth above, the operation of sensing and compensating for the updated threshold voltage of a subpixel is repeated, and after the lapse of time, differences in the threshold voltage between the driving transistors based on changes in the threshold voltage of the driving transistors are corrected. It is therefore possible to reduce or remove the differences in the luminance between the subpixels, thereby further improving image quality.

In addition, according to the present disclosure, it is possible to sense a threshold voltage and changes in the threshold voltage in more precise units in the operation of sensing an initial threshold voltage and an updated threshold voltage. It is therefore possible to better compensate for the threshold voltage, whereby no stains form on the screen having low-grayscale luminance.

### BRIEF DESCRIPTION OF THE DRAWINGS

The above and other objects, features and advantages of the present invention will be more clearly understood from the following detailed description when taken in conjunction with the accompanying drawings, in which:
FIG. 1 is a configuration diagram illustrating an organic light-emitting diode (OLED) display device according to exemplary embodiments;
FIG. 2 is a simplified equivalent circuit diagram illustrating a subpixel in the OLED display device according to the exemplary embodiments;
FIG. 3 is a circuit diagram illustrating a compensation configuration of the OLED display device according to the exemplary embodiments;
FIG. 4 illustrates a sensing operation during sensing mode in the OLED display device according to the exemplary embodiments;
FIG. 5 is a graph illustrating basic signal waveforms of a driving voltage and a data voltage and changes in the voltage of a sensing node during sensing mode in the OLED display device according to the exemplary embodiments;
FIG. 6 is a circuit diagram illustrating a sensing and compensation configuration of a subpixel in the OLED display device according to the exemplary embodiments;
FIG. 7 is a diagram illustrating an initial threshold voltage sensing and compensating configuration of a subpixel in the OLED display device according to the exemplary embodiments;
FIG. 8 is a graph illustrating changes in an initial threshold voltage when sensing and compensating for the initial threshold voltage;
FIG. 9 is a graph illustrating a basic signal waveform of a data voltage and position-specific changes in a threshold voltage when sensing and compensating for an initial threshold voltage;
FIG. 10 is a diagram illustrating an updated threshold voltage sensing and compensating configuration of a subpixel in the OLED display device according to the exemplary embodiments;
FIG. 11 is a graph illustrating changes in a threshold voltage when sensing and compensation for an updated threshold voltage;
FIG. 12 is a graph illustrating position-specific variations in a data voltage, a data compensation amount, and a threshold voltage when sensing and compensation for an updated threshold voltage;
FIG. 13 is a circuit diagram illustrating a configuration for sensing and compensating for an initial threshold voltage of a subpixel in the OLED display device according to the exemplary embodiments;
FIG. 14 is a graph showing changes in a threshold voltage when sensing and compensating for an initial threshold voltage;
FIG. 15 illustrates a sensing voltage error generated according to the output voltage resolution of the data voltage;
FIG. 16 is a circuit diagram illustrating a sensing and compensating configuration of the sub-pixel in the OLED display device 100 according to the exemplary embodiments;
FIG. 17 is a graph illustrating a gamma reference voltage applied to the data driver when sensing a threshold voltage; and
FIG. 18 is a graph illustrating an improvement in the sensed voltage error of the threshold voltage according to changes in the gamma reference voltage applied to the data driver when sensing the threshold voltage.

### DETAILED DESCRIPTION OF THE INVENTION

Reference will now be made in detail to embodiments of the present invention, examples of which are illustrated in the accompanying drawings. Throughout this document, reference should be made to the drawings, in which the same reference numerals and signs will be used to designate the same or like components.

It will also be understood that, although terms such as "first," "second," "A," "B," "(a)" and "(b)" may be used herein to describe various elements, such terms are used to distinguish one element from another element. The substance, sequence, order or number of these elements is not limited by these terms. It will be understood that when an element is referred to as being "connected to" or "coupled to" another element, not only can it be "directly connected" or "coupled to" the other element, but also can it be "indirectly connected or coupled to" the other element via an "intervening" element. In the same context, it will be understood that when an element is referred to as being formed "on" or "under" another element, not only can it be directly formed on or under another element, but it can also be indirectly formed on or under another element via an intervening element.

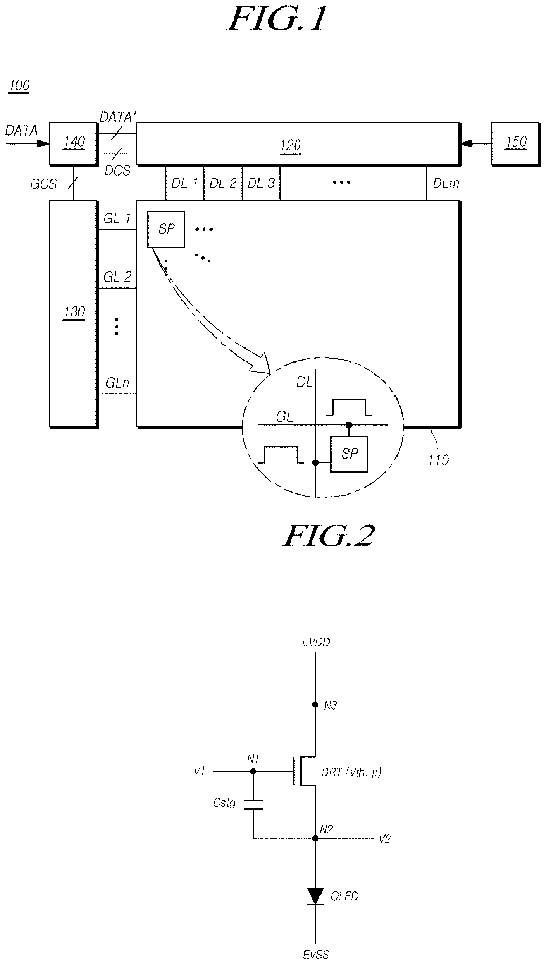

FIG. 1 is a configuration diagram illustrating an organic light-emitting diode (OLED) display device 100 according to exemplary embodiments.

Referring to FIG. 1, the OLED display device 100 according to the exemplary embodiments includes an OLED display panel 110, a data driver 120, a gate driver 130, and a timing controller 140.

On the display panel 110, a plurality of data lines DL1 to DLm are disposed in a first direction, a plurality of gate lines GL1 to GLn are disposed in a second direction, and a plurality of subpixels are disposed in the shape of a matrix. The data driver 120 drives the plurality of data lines by supplying data voltages to the plurality of data lines. The gate driver 130 sequentially drives the plurality of gate lines by sequentially supplying scanning signals to the plurality of gate lines. The timing controller 140 controls the data driver 120 and the gate driver 130 by supplying control signals to the data driver 120 and the gate driver 130.

The timing controller 140 starts scanning following the timing realized in each frame, outputs converted image data Data' by converting image data Data input by a host system into a data signal format used by the data driver 120, and regulates data processing at a suitable point in time in response to the scanning.

The gate driver 130 sequentially drives the plurality of gate lines by sequentially supplying scanning signals having an on or off voltage to the plurality of gate lines under the control of the timing controller 140.

The gate driver 130 may be positioned on one side of the OLED display panel 110 or divided into two sections positioned on opposite sides of the OLED display panel 110, according to the drive system of the OLED display panel 110.

The gate driver 130 may include a plurality of gate driver integrated circuits (ICs). The plurality of gate driver ICs may be connected to the bonding pads of the display panel 110 by a tape-automated bonding (TAB) method or a chip-on-glass (COG) method or may be implemented as a gate-in-panel (GIP)-type IC directly disposed on the display panel 110. In some cases, the plurality of gate driver ICs may be directly formed on the display panel 110, forming a portion of the display panel 110.

Each of the plurality of gate driver ICs includes a shift register, a level shifter, and the like.

When a specific gate line is opened, the data driver 120 drives the plurality of data lines by converting the image data Data' received from the timing controller 140 into analog data voltages and supplying the analog data voltages to the plurality of data lines.

The data driver 120 includes a plurality of source driver ICs. The plurality of source driver ICs may be connected to the bonding pads of the display panel 110 by a tape-automated bonding (TAB) method or a chip-on-glass (COG) method or may be directly disposed on the display panel 110. In some cases, the plurality of source driver ICs may be directly formed on the display panel 110, forming a portion of the display panel 110.

Each of plurality of source driver ICs includes a shift register, a digital-to-analog converter (DAC), an output buffer, and the like. In some cases, each source driver IC includes an analog-to-digital converter (ADC) for subpixel compensation. The ADC senses analog voltage values, converts the analog voltage values to digital values, and generates and outputs sensing data.

The plurality of source driver ICs are formed by a chip-on-film (COF) method. In each of the plurality of source driver ICs, one end is bonded to at least one source printed circuit board (SPCB), and the other end is bonded to the OLED display panel 110.

The above-mentioned host system transmits a variety of timing signals including a vertical synchronization signal Vsync, a horizontal synchronization signal Hsync, an input data enable (DE) signal, and a signal clock CLK together with digital video data Data of an input image to the timing controller 140.

The timing controller 140 converts data Data input from the host system into a data signal format used in the data driver 120 and outputs converted data Data'. In addition, the timing controller 140 receives timing signals including a vertical synchronization signal Vsync, a horizontal synchronization signal Hsync, an input DE signal, and a signal clock, generates a variety of control signals based on the input timing signals, and outputs the variety of control signals to the data driver 120 and the gate driver 130 in order to control the data driver 120 and the gate driver 130.

For example, the timing controller 140 outputs a variety of gate control signals (GCSs) including a gate start pulse (GSP), a gate shift clock (GSC) signal and a gate output enable (GOE) signal in order to control the gate driver 130. The GSP controls the operation start timing of the gate driver ICs of the gate driver 130. The GSC signal is a clock signal commonly input to the gate driver ICs to control the shift timing of scanning signals (gate pulses). The GOE signal designates the timing information of the gate driver ICs.

The timing controller 140 outputs a variety of data control signals (DCSs) including a source start pulse (SSP), a source sampling clock (SSC) signal and a source output enable (SOE) signal in order to control the data driver 120. The SSP controls the data sampling start timing of the source driver ICs of the data driver 120. The SSC signal is a clock signal to control the data sampling timing of each of the source driver ICs. The SOE signal controls the output timing of the data driver 120. In some cases, DCSs may further include a polarity (POL) control signal in order to control the polarity of data voltages of the data driver 120. The SSP and SSC signal may be omitted when data Data' input into the data driver 120 is transmitted based on the mini low voltage differential signaling (LVDS) interface specification.

Referring to FIG. 1, the OLED display device 100 further includes a power controller 150 that supplies a variety of voltages or currents to the OLED display panel 110, the data driver 120, the gate driver 130, and the like, or controls the variety of voltages or currents to be supplied to the OLED display panel 110, the data driver 120, the gate driver 130, and the like.

The power controller is also referred to as a power management IC (PMIC).

FIG. 2 is a schematic equivalent circuit diagram illustrating a subpixel in the OLED display device 100 according to the exemplary embodiments.

Referring to FIG. 2, each pixel of the OLED display device 100 includes an OLED and a driving circuit driving the OLED. The driving circuit includes a driving transistor DRT driving the OLED by supplying a current to the OLED.

A first node N1 of the driving transistor DRT is a gate node, to which a voltage V1 is applied. A second node N2 of the driving transistor DRT is a source node or a drain node, to which a voltage V2 is applied. A third node N3 of the driving transistor DRT is a drain node or a source node, to which a driving voltage EVDD is applied. Here, the voltage V1 may be a data voltage Vdata corresponding to a relevant subpixel. There is a predetermined potential difference between the voltage V1 and the voltage V2. For example, the voltage V2 may be a reference voltage Vref.

The driving circuit includes a storage capacitor Cstg connecting the first node N1 and the second node N2 of the driving transistor DRT. The storage capacitor Cstg maintains a constant voltage for a period of a single frame.

FIG. 2 schematically and equivalently illustrates the circuit configuration of each of the subpixels. In practice, the driving circuit of each of the subpixels, which drives the OLED, may further include one or more driving transistors in addition to the driving transistor DRT and the storage capacitor Cstg. In some cases, the driving circuit may further include one or more capacitors.

The transistors in each of the subpixels, more particularly, the driving transistor DRT has unique characteristics, such as a threshold voltage Vth, mobility µ, and the like.

The transistor (in particular, the driving transistor DRT) may degrade along with the lapse of driving period, whereby the unique characteristics thereof may change. Thus, the unique characteristics of one driving transistor may be different from those of another driving transistor. Such differences in the characteristics between the driving transistors may cause differences in the degrees of luminance of a subpixel, thereby degrading image quality.

The OLED display device 100 includes a compensation configuration that provides a compensation function for compensating for the differences in the luminance between subpixels.

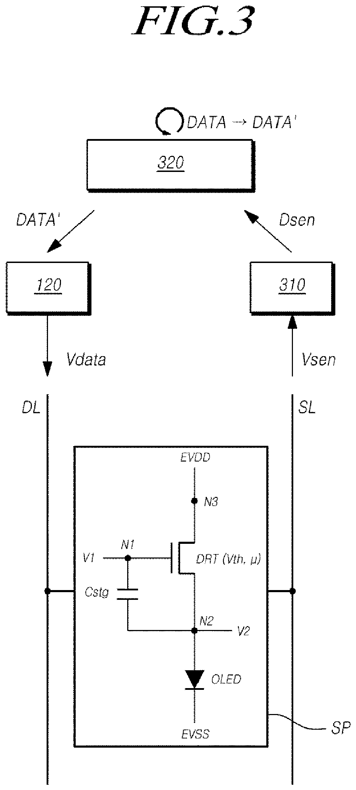

FIG. 3 is a circuit diagram illustrating a compensation configuration of the OLED display device 100 according to the exemplary embodiments.

Referring to FIG. 3, the OLED display device 100 includes a sensor 310, a compensation circuit 320, the data driver 120, and the like.

The sensor 310 senses a voltage of a sensing node (SN) in each pixel SP and transmits sensed data Dsen to the compensation circuit 320 based on the sensed voltage Vsen. The sensor 310 may be, for example, an ADC.

The ADC may be electrically connected to the sensing node in each pixel through a sensing line SL. The ADC converts the voltage Vsen of the sensing node, sensed through the sensing line SL electrically connected to the sensing node SN in the each pixel, into digital values and generates the sensed data Dsen based on the converted digital values.

The sensor 310 corresponding to the ADC may be provided in plurality, and a single sensor 310, that is, a single ADC may be included in a single source driver IC.

The compensation circuit 320 performs a compensation process based on the received sensed data Dsen. The compensation process may be the process of determining a data compensation amount ΔData by which data Data of each of the subpixels is changed based on the received sensed data Dsen and saves the data compensation amount ΔData in a memory (not shown).

In addition, the compensation process may include an operation of changing the data Data output from a host system based on the data compensation amount ΔData. The data changing operation may acquire changed data Data' by adding the data compensation amount ΔData to the data Data outputted from the host system (Data'=Data+ΔData).

The compensation circuit 320 may be disposed within the timing controller 140.

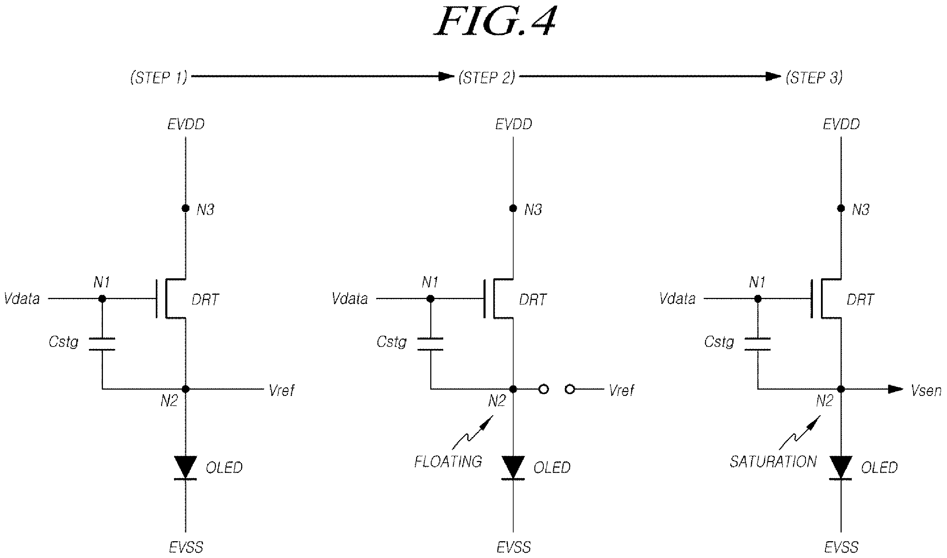

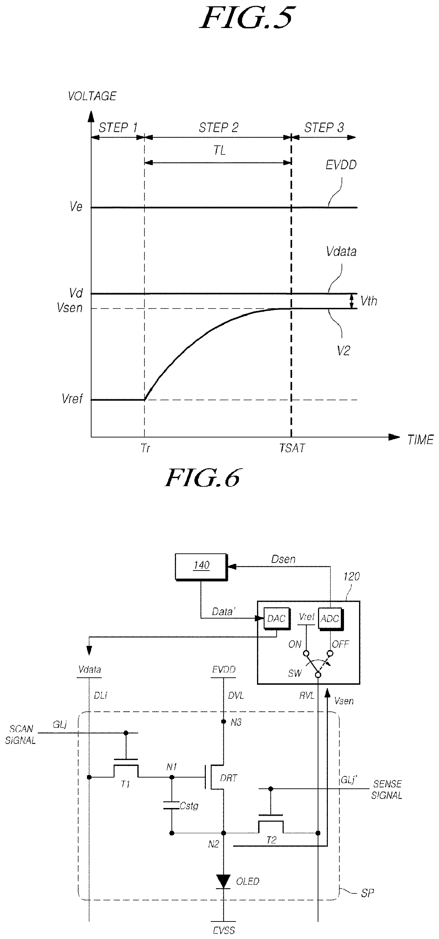

A description of a method and principle of sensing a threshold voltage of the driving transistor DRT in the each pixel on the OLED display panel 110 will be described with reference to FIG. 4 and FIG. 5.

FIG. 4 illustrates a sensing operation during sensing mode in the OLED display device 100 according to the exemplary embodiments. FIG. 5 is a graph illustrating basic signal waveforms of a driving voltage and a data voltage and changes in the voltage of a sensing node during sensing mode in the OLED display device according to the exemplary embodiments.

Referring to FIG. 4 and FIG. 5, the sensing operations in the sensing mode of the OLED display device 100 according to the exemplary embodiments include an initializing operation ①, a sensing node floating operation ②, and a sensing node sensing operation ③.

In the initializing operation ①, after a sensing mode is enabled, a data voltage Vdata and a reference voltage Vref are applied to a first node N1 and a second node N2 of a DRT in a relevant subpixel. It is assumed that the first node N1 of the driving transistor DRT is a gate node of the driving transistor DRT and the second node N2 is a source node of the driving transistor DRT. In addition, it is assumed that the source node of the driving transistor DRT is a sensing node in the relevant subpixel.

In the sensing node floating operation ②, the second node N2 of the driving transistor DRT, i.e. the source node thereof, is floated at a time Tr. The first node N1 of the driving transistor DRT is in the state in which the data voltage Vdata corresponding to an initialization voltage is applied thereto. As the second node N2 of the driving transistor DRT, i.e. the source node thereof, is floated, the voltage of the second node N2 of the driving transistor DRT is boosted.

The voltage of the source node of the driving transistor DRT is boosted toward the data voltage Vdata corresponding to the voltage of the first node N1 of the driving transistor DRT. The voltage boosting continues until the difference between the voltage of the source node and the data voltage Vdata corresponding to the voltage of the first node N1 of the driving transistor DRT reaches the threshold voltage Vth.

As described above, in the second node N2 of the driving transistor DRT, i.e. the source node thereof, the voltage boosting toward the voltage of the first node N1 is called "source following."

In the sensing node sensing operation ③, when the boosting voltage of the second node N2 of the driving transistor DRT is saturated at a point in time Tsat, the saturated voltage of the second node N2 of the driving transistor DRT is sensed.

The voltage saturated in the second node N2 of the driving transistor DRT, i.e. the source node thereof, becomes a voltage (Vdata - Vth = Vd - Vth) obtained by subtracting the threshold voltage Vth of the driving transistor DRT from the data voltage Vdata corresponding to the voltage of the first node N1 of the driving transistor DRT. Here, FIG. 5 illustrates the case in which the threshold voltage Vth of the driving transistor DRT has a positive value. The threshold voltage Vth of the driving transistor DRT may have a negative value.

In the sensing mode, the data voltage Vdata has a constant voltage Vd, and a driving voltage EVDD has a constant voltage Ve.

In the sensing mode, the voltage of the second node N2 of the driving transistor DRT must be sampled and sensed (measured) by the ADC corresponding to the sensor 310 after the voltage of the sensing node of the relevant pixel, i.e. the second node N2 of the driving transistor DRT, is saturated in order to more accurately sense the threshold voltage Vth of the driving transistor DRT.

FIG. 6 is a circuit diagram illustrating a sensing and compensation configuration of a subpixel in the OLED display device 100 according to the exemplary embodiments.

Referring to FIG. 6, each of the subpixels SP includes: an OLED; a driving transistor DRT having a first node N1 to which a data voltage is applied, a second node N2 connected to a first electrode of the OLED, and a third node electrically connected to a driving voltage line DVL; a first transistor T1 electrically connected between a data line DLi through which the data voltage is supplied and a first node N1 of the driving transistor DRT; a second transistor T2 electrically connected between a reference voltage line RVL through which a reference voltage is supplied and the second node N2 of the driving transistor DRT; and a capacitor Cstg electrically connected between the first node N1 and the second node N2 of the driving transistor DRT.

The subpixel SP also includes an ADC or is coupled to an ADC as a configuration for sensing a saturated voltage of the second node N2 of the driving transistor DRT. The ADC is electrically connected to the reference voltage line RVL, and senses a voltage of the second node N2 of the driving transistor DRT.

The ADC is electrically connected to a plurality of reference voltage lines RVL. A single ADC may be provided in every source driver IC.

The use of the above-described ADC allows for efficient and accurate sensing of the threshold voltage of the driving transistor DRT in the subpixel.

Referring to FIG. 6, the analog digital converter ADC senses the voltage of the second node N2 of the driving transistor DRT, converts the sensed voltage Vsen into digital values, and transmits sensed data Dsen including the converted digital values to the time controller 140.

The timing controller 140 receives the sensed data Dsen and compensates for data of each of the subpixels based on the received sensed data Dsen.

For example, the timing controller 140 calculates a data compensation amount ΔData of each of the subpixels based on the sensed data Dsen, saves the calculated data compensation amount ΔData in a memory (not shown), adds the data compensation amount ΔData to data Data about a relevant pixel at a point in time to drive subpixels, and supplies resultant compensated data Data' to a relevant data driver 120 (Data'=Data+ΔData).

As described above, a difference in the threshold voltage between the driving transistors DRTs is compensated through the data compensation. This can reduce or remove differences in luminance between the subpixels, thereby improving image quality.

In the sensing mode, an initial threshold voltage Vth of the driving transistor DRT is sensed by source following, differences in the threshold voltage between the driving transistors DRTs are compensated through the data compensation, a change in threshold voltage (hereinafter referred to as a "threshold voltage change") ΔVth in each DRT is updated and sensed, and a difference in the threshold voltage (Vth+ΔVth) between the driving transistors DRTs is compensated by the data compensation, thereby improving compensation efficiency.

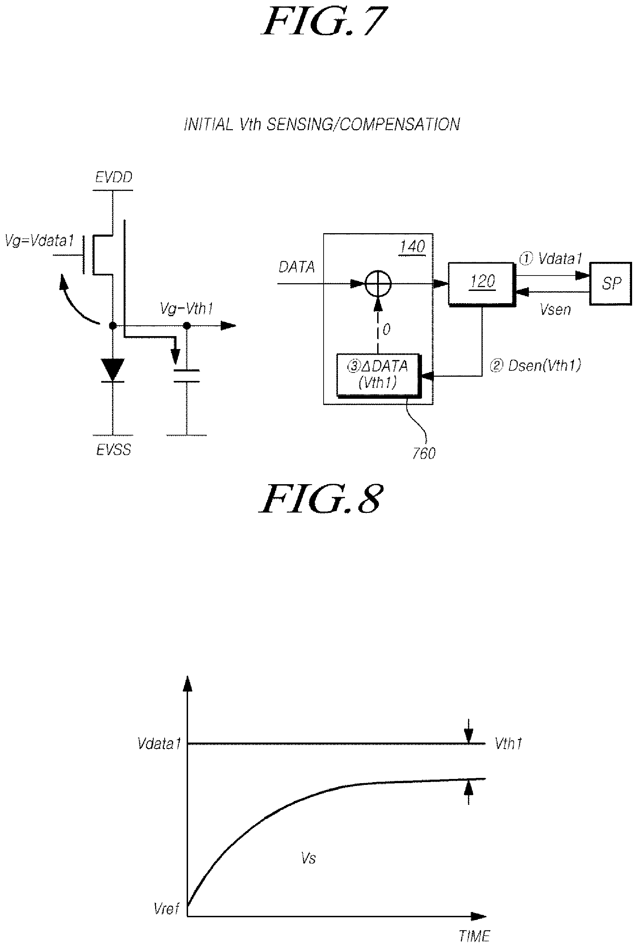

FIG. 7 is a diagram illustrating an initial threshold voltage sensing and compensating configuration of a subpixel in the OLED display device 100 according to the exemplary embodiments. FIG. 8 is a graph illustrating changes in an initial threshold voltage when sensing and compensating for the initial threshold voltage. In FIG. 7, digital values are represented as corresponding analog values.

Referring to FIG. 7 and FIG. 8, when sensing and compensating for the initial threshold voltage of the subpixel in the OLED display device 100 according to the exemplary embodiments, in an initializing operation ①, a data voltage Vdata1 and a reference voltage Vref are applied to a first node N1 and a second node N2 of a DRT in a relevant pixel. Afterwards, as the second node N2 of the driving transistor DRT, i.e. the source node thereof, is floated, the voltage of the second node N2 of the driving transistor DRT is boosted.

The voltage of the source node of the driving transistor DRT is boosted toward the data voltage Vdata1 corresponding to the voltage of the first node N1 of the driving transistor DRT as illustrated in FIG. 8. The voltage boosting continues until the difference between the voltage of the source node and data voltage Vdata1 corresponding to the voltage of the first node N1 of the driving transistor DRT reaches the threshold voltage Vth1.

In a sensing node sensing operation ②, when the boosting voltage of the second node N2 of the driving transistor DRT is saturated, the saturated voltage Vg - Vth1 = Vdata1 - Vth1 of the second node N2 of the driving transistor DRT is sensed.

The ADC of the data driver 120 senses the voltage of the second node N2 of the driving transistor DRT, converts the sensed voltage Vsen into digital values, and transmits the sensed data Dsen (Vth1) to the timing controller 140. The sensed data Dsen (Vth1) includes the converted digital values from the sensed voltage Vsen.

The timing controller 140 calculates a data compensation amount ΔData (Vth1) of each of the subpixels based on the sensed data Dsen (Vth1), and saves the calculated data compensation amount ΔData (Vth1) in a memory 760. For example, as illustrated in FIG. 7, the timing controller 140 calculates the data compensation amount ΔData (ΔVth1) of each of the subpixels using the sensed voltage Vsen corresponding to the sensed data Dsen (Vth1), and saves the calculated result in the memory 760. The initial threshold voltage Vth1 is obtained by subtracting the data voltage Vdata1 from the saturated voltage Vg - Vth1 = Vdata1 - Vth1 of the second node N2 of the driving transistor DRT which is the sensed voltage Vsen. The timing controller 140 save the obtained initial threshold voltage Vth1 in the memory 760 as the data compensation amount ΔData (ΔVth1).

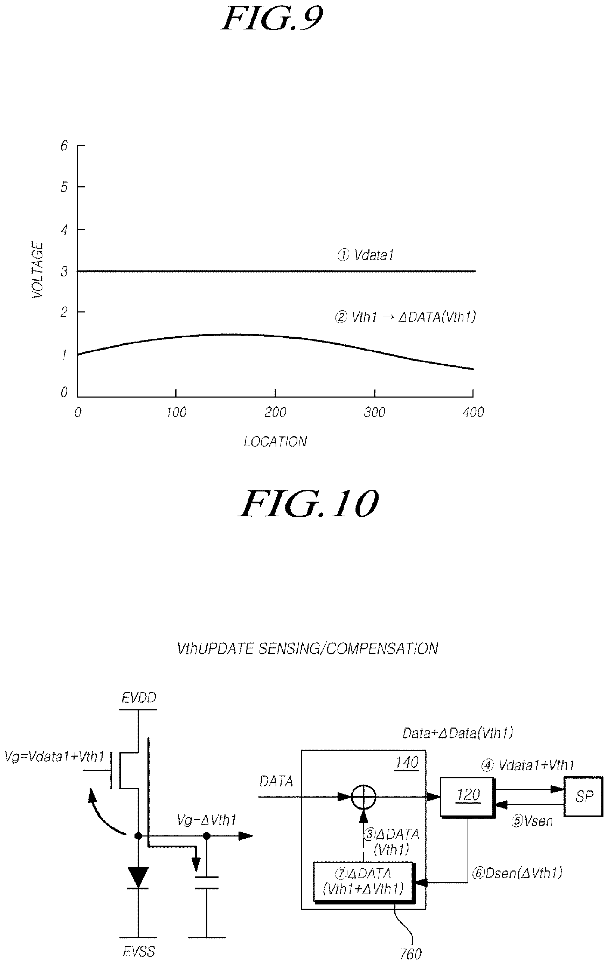

Since the sensed initial threshold voltage Vth1 varies according to the driving transistor DRTs, differences in the threshold voltage between the driving transistors DRTs occur. FIG. 9 is a graph illustrating a basic signal waveform of a data voltage and position-specific changes in a threshold voltage when sensing and compensating for an initial threshold voltage.

In a subpixel compensating operation ③ from FIG. 7, at a point in time to drive subpixels, the timing controller 140 adds the data compensation amount ΔData (Vth1) to data Data about a relevant pixel SP, and supplies the obtained compensated data Data' = Data + ΔData (Vth1) to the relevant data driver 120. The data driver 120 supplies a compensated data voltage Vdata1' = Vdata1 + Vth1 to the relevant subpixel SP. Here, the compensated data voltage Vdata1' = Vdata1 + Vth1 is obtained by adding the initial threshold voltage Vth1 to the data voltage Vdata1 of the relevant subpixel SP.

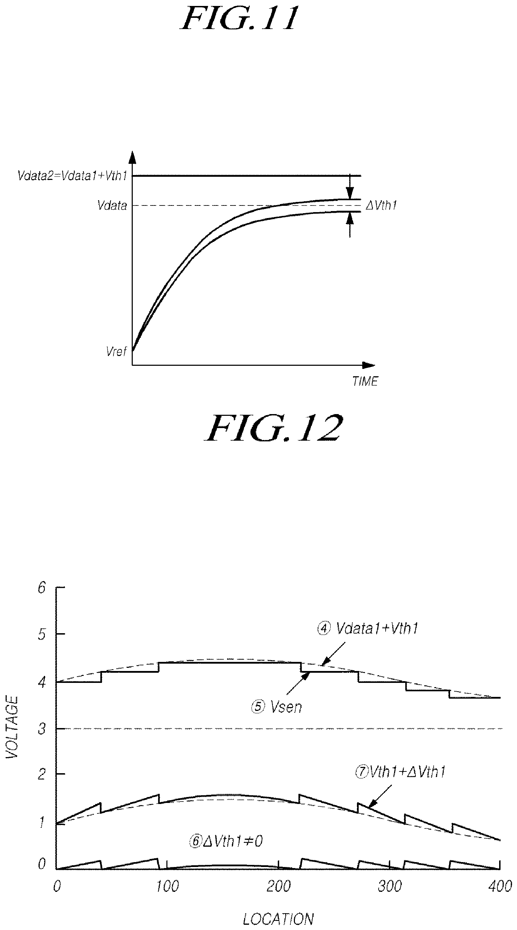

FIG. 10 is a diagram illustrating an updated threshold voltage sensing and compensating configuration of a subpixel in the OLED display device 100 according to the exemplary embodiments. FIG. 11 is a graph illustrating changes in a threshold voltage when sensing and compensation for an updated threshold voltage.

Referring to FIG. 10 and FIG. 11, when sensing and compensating for the updated initial threshold voltage of the subpixel in the OLED display device 100 according to the exemplary embodiments, in operation ④, a compensated data voltage Vdata2 = Vdata1 + Vth1, obtained by adding the initial threshold voltage Vth1 to the data voltage Vdata1 of the relevant subpixel, is applied to the first node N1 of the driving transistor DRT in the relevant subpixel, and a reference voltage Vref is applied to the second node N2. In a sensing node floating operation, as the second node N2 of the driving transistor DRT, i.e. the source node thereof, is floated, the voltage of the second node N2 of the driving transistor DRT is boosted.

As indicated by ⑤ in FIG. 10, the voltage of the source node of the driving transistor DRT is boosted toward the data voltage Vdata2 corresponding to the voltage of the first node N1 of the driving transistor DRT (gate of DRT) as illustrated in FIG. 11. Assuming the threshold voltage of the drive transistor DRT has not changed, the voltage boosting ⑤ is performed until the source node voltage reaches the value Vdata2 - Vth1 = (Vdata1 + Vth1) - Vth1, which is the difference between the threshold voltage Vth1 and the compensated data voltage Vdata2 = Vdata1 + Vth1. However, when the previously sensed threshold voltage Vth of the driving transistor DRT changes with the lapse of time, the voltage boosting ⑤ of the source node of the driving transistor DRT continues until the source node voltage is Vdata2 - ΔVth1 = (Vdata1 + Vth1) - ΔVth1, which is the difference between the compensated data voltage Vdata2 = Vdata1 + Vth1 and the threshold voltage change ΔVth1.

In a threshold voltage change sensing operation ⑥, a saturated voltage Vdata2 - ΔVth1 = (Vdata1 + Vth1) - ΔVth1 of the second node N2 of the driving transistor DRT is sensed.

The ADC of the data driver 120 senses the voltage of the second node N2 of the driving transistor DRT, converts the sensed voltage Vsen into digital values, and transmits the sensed data Dsen (ΔVth1) including the converted digital values to the timing controller 140. The notation Dsen (ΔVth1) refers to a Dsen value that is sensed when the transistor threshold has changed by ΔVth1.

In data compensation amount calculating operation ⑦, the timing controller 140 calculates the threshold voltage change ΔVth1 and a resultant data compensation amount ΔData of each of the subpixels based on the sensed data Dsen (ΔVth1), and saves the calculated threshold voltage change ΔVth1 and the data compensation amount ΔData in the memory 760. For example, as illustrated in FIG. 10, the timing controller 140 calculates the data compensation amount ΔData (Vth1 + ΔVth1), i.e. the initial threshold voltage Vth1 and threshold voltage change ΔVth1, of each of the subpixels, using the sensed voltage Vsen corresponding to the sensed data Dsen, and saves the calculated result in the memory 760. Here, the threshold voltage change ΔVth1 is obtained by subtracting the compensated data voltage Vdata2=Vdata1+Vth1 from the saturated voltage Vdata2 - ΔVth1 = (Vdata1 + Vth1) - ΔVth1 of the second node N2 of the driving transistor DRT.

FIG. 12 is a graph illustrating position-specific variations in a data voltage, a data compensation amount, and a threshold voltage when sensing and compensating for an updated threshold voltage.

In the subpixel compensation operation, to drive subpixels, the timing controller 140 adds the data compensation amount ΔData (Vth1 + ΔVth1) to data about a relevant subpixel, and supplies resultant compensated data Data' = Data + ΔData (Vth1 + ΔVth1) to the corresponding data driver 120. The data driver 120 supplies a compensated data voltage Vdata' obtained by adding the initial threshold voltage Vth1 and a threshold voltage change ΔVth1 to the data voltage Vdata1 of the corresponding subpixel.

The OLED display device 100 according to the exemplary embodiments repeats the operation of sensing and compensating for the updated threshold voltage of a subpixel, which has been described with reference to FIG. 10. After the lapse of time, differences in the threshold voltage between the driving transistors are corrected based on the threshold voltage changes of the driving transistors. This can reduce or remove the differences in the luminance between the sub-pixels, thereby improving image quality.

In the OLED display device 100 according to the exemplary embodiments as described above, the DAC of the data driver 120 applying a data voltage to a relevant subpixel, the ADC sensing a threshold voltage Vth, and the memory 760 saving a threshold voltage change ΔVth of the subpixel and a data compensation amount ΔData of the subpixel calculated based on the sensed data Dsen may have different resolutions. A threshold voltage sensing and compensating structure using a DAC, an ADC, and a memory having different resolutions will now be described with reference to the drawings.

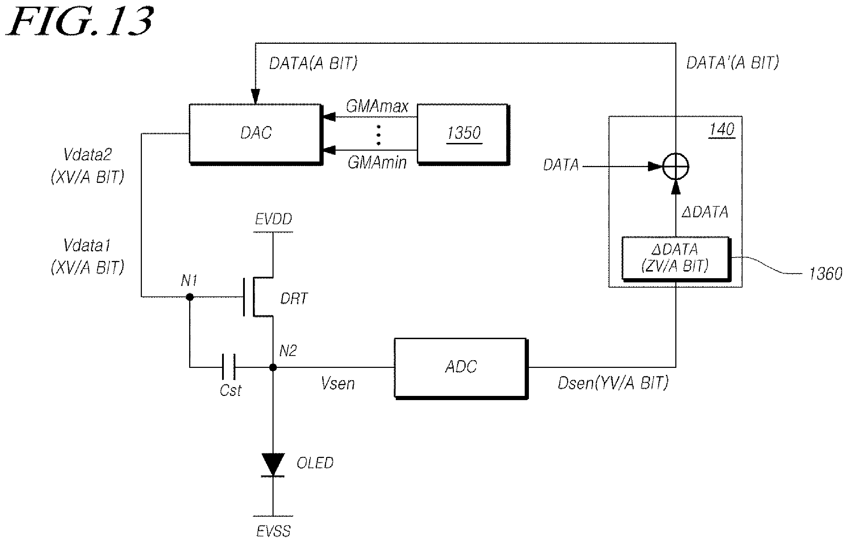

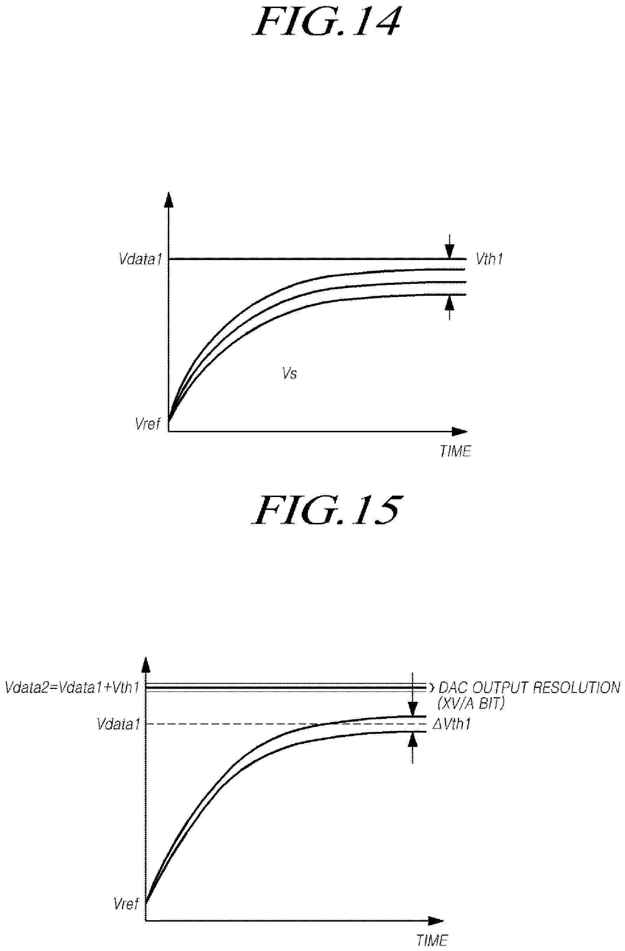

FIG. 13 is a circuit diagram illustrating a configuration for sensing and compensating for an initial threshold voltage of a subpixel in the OLED display device 100 according to the exemplary embodiments. FIG. 14 is a graph illustrating changes in a threshold voltage when sensing and compensating for the initial threshold voltage.

Referring to FIG. 13 and FIG. 14, the DAC provides the drive transistor DRT with a data voltage Vdata corresponding to the data in the sensing and driving operation. The data may be, for example, A-bit video data.

Further, a gamma reference voltage supply circuit 1350 provides the DAC with 2^{A} gamma reference voltages corresponding to A bits. The gamma reference voltage supply circuit 1350 may be included in the power controller 150 described with reference to FIG. 1, but the present invention is not limited thereto.

A maximum gamma reference voltage may be, for example, X Volts (V). The DAC receives the A-bit data from the timing controller 140 and the 2^{A} gamma reference voltages from the gamma reference voltage supply circuit 1350, and provides 2^{A} data voltages Vdata1 to the drive transistor DRT. Thus, an output voltage resolution of the DAC is X V / A bits, and can be expressed as X/2^{A} V per one bit.

When sensing and compensating for the initial threshold voltage of the subpixel of the OLED display device 100 according to the exemplary embodiments, in the initializing operation ①, the DAC applies a fixed voltage, for example, a data voltage Vdata1 of a V (i.e. "a" Volts), to a first node N1 of the drive transistor DRT within the relevant subpixel. Further, it is assumed that the reference voltage Vref is b V (i.e. "b" Volts).

Afterwards, as a second node N2 of the drive transistor DRT, i.e. a source node of the drive transistor DRT, is floated, the voltage of the source node of the drive transistor DRT is boosted toward the data voltage Vdata1 corresponding to a voltage of the first node N1 of the drive transistor DRT, as illustrated in FIG. 14. The voltage boosting continues until the difference between the voltage of the source node of the drive transistor DRT and the data voltage Vdata1 corresponding to the voltage of the first node N1 of the drive transistor DRT reaches the initial threshold voltage Vth1.

The ADC sensing the voltage of the first node N1 of the drive transistor DRT converts a peak voltage, for example, a sensed voltage Vsen of Y V (i.e. "Y" Volts), into A-bit sensed data Dsen, and transmits the sensed data Dsen to the timing controller 140. Therefore, the sensing voltage resolution of the ADC is Y V / A bits, and can be expressed as Y/2^{A} V per one bit.

In the sensing node sensing operation ②, the ADC can sense the saturated voltage Vg - Vth1 = Vdata1 - Vth1 of the second node N2 of the drive transistor DRT in units of Y/2^{A} V. The sensed voltage Vsen (Vth1) of the ADC can be expressed only in increments of Y/2^{A} V as in FIG. 14 and Table 1.

**Table 1**

| Sensed Vth1(V) | ADC output |
|---|---|
| Y/2^{A} | 1 |
| 2Y/2^{A} | 2 |
| 3Y/2^{A} | 3 |
| 4Y/2^{A} | 4 |
| 5Y/2^{A} | 5 |
| 6Y/2^{A} | 6 |

The timing controller 140 calculates the initial threshold voltage Vth1 by subtracting the data voltage Vdata1 from the sensed voltage Vsen corresponding to the sensed data Dsen, i.e. the saturated voltage Vg - Vth1 = Vdata1 - Vth1 of the second node N2 of the drive transistor DRT, and saves the calculated result in the memory 1360 as the data compensation amount ΔData.

The timing controller 140 saves the threshold voltage Vth1 in the memory 1360 as a voltage per unit bit that is higher than the sensed voltage per unit bit of the ADC.

When calculating the data compensation amount ΔData (Vth1) of each of the sub-pixels, the timing controller 140 may calculate the data compensation amount ΔData (Vth1) in units of Y V/A-bits = Y/2^{A} V/bit, which is the sensing voltage resolution of the ADC. To increase a compensation range to compensate for the initial threshold voltage with wide dispersion, the basic unit of the data compensation amount ΔData (Vth1) can be changed. For example, the timing controller 140 calculates the threshold voltage Vth1 of each of the subpixels, for example, in units of Z V/A-bits = Z/2^{A} V/bit and saves the calculated result in the memory 1360 as the data compensation amount ΔData. Here, Z may be greater than Y. Hereinafter, it is assumed that Z = 2Y, but this is not intended to be limiting.

**Table 2**

| Sensed Vth1(V) | Value stored as ΔData |
|---|---|
| Y/2^{A} | 1 |
| 2Y/2^{A} | 1 |
| 3Y/2^{A} | 2 |
| 4Y/2^{A} | 2 |
| 5Y/2^{A} | 3 |
| 6Y/2^{A} | 3 |

In the subpixel compensating operation ③, to drive the subpixels at a point of time, the timing controller 140 converts the data compensation amount ΔData (Vth1) saved in the memory 1360 to be harmonious with the output voltage resolution (X/2^{A} V/bit) of the DAC as in Table 3, and supplies the compensated data Data1' = Data1 + ΔData (Vth1) to the data driver 120.

**Table 3**

| Sensed Vth1(V) | Down-converted ΔData value |
|---|---|
| Y/2^{A} | 1 |
| 2Y/2^{A} | 1 |
| 3Y/2^{A} | 1 |
| 4Y/2^{A} | 1 |
| 5Y/2^{A} | 1 |
| 6Y/2^{A} | 1 |

Similarly, when sensing and compensating for the updated threshold voltage of a subpixel, in operation ④, the DAC applies the compensated data voltage Vdata1' = Vdata1 + Vth1 corresponding to the compensated data Data1' = Data1 + ΔData (Vth1) of the relevant sub-pixel to the first node N1 of the drive transistor DRT within the relevant subpixel. The data voltage Vdata is fixed as a V, and the data compensation amount ΔData (Vth1) converted to be harmonious with the output voltage resolution (X/2^{A} V/bit) of the DAC is as in Table 3. The compensated data voltage Vdata1' = Vdata1 + Vth1 is as in Table 4. That is, the output voltage resolution X/2^{A} V/bit of the DAC is lower than the sensing voltage resolution Y/2^{A} V/bit of the ADC, and the other threshold voltages are calculated in terms of the same data compensation amount ΔData (Vth1).

**Table 4**

| Sensed Vth1 (V) | Applied Voltage(V) (DAC output) |
|---|---|
| Y/2^{A} | a + X/2^{A} |
| 2Y/2^{A} | a + X/2^{A} |
| 3Y/2^{A} | a + X/2^{A} |
| 4Y/2^{A} | a + X/2^{A} |
| 5Y/2^{A} | a + X/2^{A} |
| 6Y/2^{A} | a + X/2^{A} |

In the threshold voltage change sensing operation ⑥, the ADC can sense the saturated voltage Vdata2 - (Vth1 + ΔVth1) = Vdata1 - ΔVth1 of the second node N2 of the drive transistor DRT in units of Y/2^{A} V. The threshold voltage variation according to the initial threshold voltage Vth1 is as in Table 5.

**Table 5**

| Vth1(V) | Sensed ΔVth1(V) | ADC output |
|---|---|---|
| Y/2^{A} | -5Y/2^{A} | -5 |
| 2Y/2^{A} | -4Y/2^{A} | -4 |
| 3Y/2^{A} | -3Y/2^{A} | -3 |
| 4Y/2^{A} | -2Y/2^{A} | -2 |
| 5Y/2^{A} | -Y/2^{A} | -1 |
| 6Y/2^{A} | 0 | 0 |

In the data compensation amount calculating operation ⑦, the timing controller 140 saves the threshold voltage variation ΔVth1 of the ADC in the memory 1360 as a voltage higher than the sensing voltage per unit bit of the ADC.

In the data compensation amount calculating operation ⑦, when calculating the data compensation amount ΔData (Vth1 + ΔVth1) of each of the subpixels, the timing controller 140 may calculate the data compensation amount ΔData (Vth1 + ΔVth1) in units of Y V/A-bits or Y/2^{A} V/bit that is the sensing voltage resolution of the ADC, but may change the basic unit of the data compensation amount ΔData (Vth1) in order to increase the compensation range to compensate for the initial threshold voltage with the wide dispersion. For example, the timing controller 140 calculates the data compensation amount ΔData (Vth1 + ΔVth1) in units of Z V/A-bit = Z/2^{A} V/bit as in Table 6.

**Table 6**

| Sensed ΔVth1(V) | ΔData update value(Bit) |
|---|---|
| -5Y/2^{A} | -2 |
| -4Y/2^{A} | -2 |
| -3Y/2^{A} | -1 |
| -2Y/2^{A} | -1 |
| -Y/2^{A} | 0 |
| 0 | 0 |

The timing controller 140 calculates the threshold voltage variation ΔVth1 of each of the relevant subpixels and the initial threshold voltage Vth1, and saves the calculated result in the memory 1360 as the final or updated data compensation amount ΔData (Vth1 + ΔVth1) as in Table 7.

**Table 7**

| Initial Vth1(V) | Sensed ΔVth1(V) | Updated Vth2 (V) | Value stored as ΔData(Bit) |
|---|---|---|---|
| Y/2^{A} | -5Y/2^{A} | -4Y/2^{A} | -2 |
| 2Y/2^{A} | -4Y/2^{A} | -2Y/2^{A} | -1 |
| 3Y/2^{A} | -3Y/2^{A} | 0 | 0 |
| 4Y/2^{A} | -2Y/2^{A} | 2Y/2^{A} | 1 |
| 5Y/2^{A} | -Y/2^{A} | 4Y/2^{A} | 2 |
| 6Y/2^{A} | 0 | 6Y/2^{A} | 3 |

Since the OLED display device 100 according to the exemplary embodiments repeats the operation of sensing and compensating for the updated threshold voltage of the subpixel, the OLED display device 100 corrects the threshold voltage deviation between the drive transistors by reflecting the threshold voltage variation of each of the drive transistors after a predetermined time has elapsed, thereby reducing or removing differences in the luminance between the subpixels. Thereby, it is possible to improve image quality.

FIG. 15 illustrates a sensing voltage error generated according to the output voltage resolution of the data voltage Vdata.

Referring to FIG. 15, when sensing the initial threshold voltage and the updated threshold voltage of the aforementioned display device, the DAC of the data driver 120 expresses the output gamma reference voltage as A bits. Thus, the data voltage Vdata or Vdata' applied to the gate of the drive transistor DRT of each sub-pixel is expressed by diving the output voltage of the DAC of the data driver 120 by the A bits. Therefore, the DAC of the data driver 120 has a limit to precisely outputting the data voltage Vdata or Vdata' applied to the gate of the drive transistor DRT of each sub-pixel because the magnitude of the voltage corresponding to 1 bit is set to in X/2^{A} V/bit in the aforementioned example. The output voltage resolution of the DAC of the data driver 120 is insufficient, and the ability to precisely sensing the threshold voltage Vth1 and the threshold voltage variation ΔVth2 is limited.

Upon sensing the initial threshold voltage and the updated threshold voltage of the aforementioned display device, since the threshold voltage Vth1 and the threshold voltage variation ΔVth1 are not sensed in a more precise unit, the compensation for the threshold voltage Vth is not perfect and stains may form on a screen having low-grayscale luminance.

In the OLED display device 100 according to the exemplary embodiments as described above, there may be a difference in resolution between the DAC of the data driver 120 which applies the data voltage Vdata to the sub-pixel of interest, the ADC that senses the threshold voltage Vth, and the memory 1360 that stores the result obtained by calculating the threshold voltage variation ΔVth of each of the sub-pixels and the resultant data compensation amount ΔData based on the sensing data Dsen. Hereinafter, a structure for sensing and compensating for the threshold voltage using the DAC, the ADC, and the memory that have different resolutions will be described with reference to the drawings.

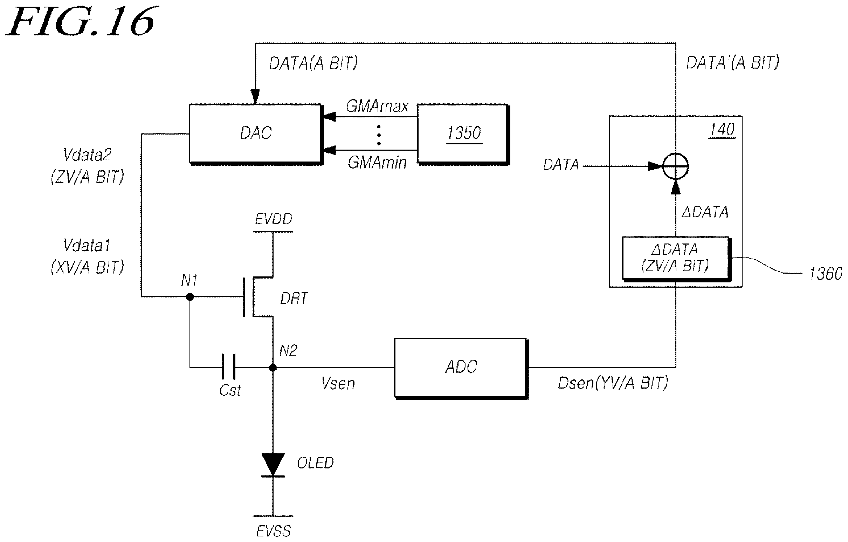

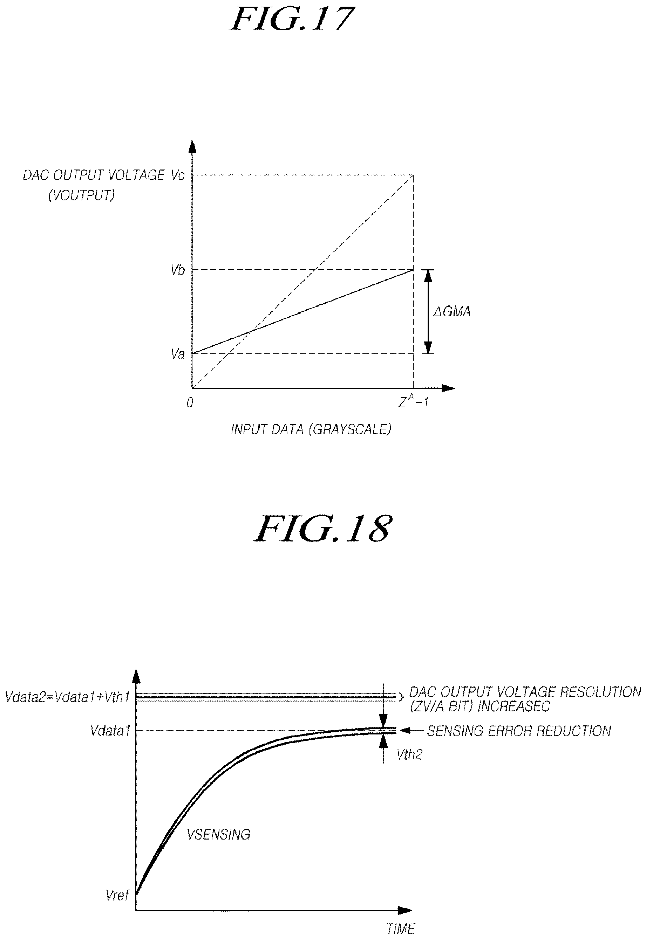

FIG. 16 is a circuit diagram illustrating a sensing and compensating configuration of the sub-pixel in the OLED display device 100 according to the exemplary embodiments. FIG. 17 is a graph illustrating a gamma reference voltage applied to the data driver when sensing a threshold voltage.

Referring to FIG. 16, in the event of sensing and driving operations, the DAC provides a data voltage Vdata corresponding to data Data to the gate of the drive transistor DRT. Here, the data Data may include A-bit image data. Further, the gamma reference voltage supply circuit 1350 provides 2^{A} gamma reference voltages corresponding to "A" bits to the DAC.

As illustrated in FIG. 17, gamma reference voltages which the gamma reference voltage supply circuit 1350 applies to the data driver may be varied. The gamma reference voltage supply circuit 1350 supplies gamma reference voltages within a gamma reference voltage range ΔGMA between the minimum gamma reference voltage GMAmin and the maximum gamma reference voltage GMAmax, and varies at least one of the minimum gamma reference voltage GMAmin and the maximum gamma reference voltage GMAmax to be able to vary the gamma reference voltages.

In the event of the initial threshold voltage sensing operation and the driving operation, the minimum gamma reference voltage GMAmin may be 0 V, and the maximum gamma reference voltage GMAmax may be Vc V. Further, when updating the threshold voltage, the minimum gamma reference voltage GMAmin may be Va V, and the maximum gamma reference voltage GMAmax may be Vb V. Therefore, the DAC may express A-bit data as Vc V/A-bits (or Vc/2^{A} V/bit) in the event of the initial threshold voltage sensing operation and the driving operation, and as (Vb-Va)/A-bits (or (Vb-Va)/2^{A} V/bit) when updating the threshold voltage. When updating the threshold voltage, an output voltage resolution of the DAC can be increased.

When outputting the data voltage of the DAC, if the range of the output data voltages is reduced, the data voltage capable of expressing the same number of bits is made smaller. When the display device actually drives an image, the range of the output data voltages should be great, but the range of the output data voltages used when sensing the threshold voltage is narrower. For this reason, in the event of the sensing operation, the range of the output data voltages is reduced. Thereby, it is possible to increase sensing voltage resolutions of the threshold voltage Vth and the threshold voltage variation ΔVth.

For example, in the event of the initial threshold voltage sensing operation and the driving operation, the maximum gamma reference voltage GMAmax may be, for example, X V. Therefore, the DAC receives the A-bit data Data from the timing controller 140 and the 2^{A} gamma reference voltages from the gamma reference voltage supply circuit 1350, and provides 2^{A} data voltages Vdata1 to the gate of the drive transistor DRT. As a result, the output voltage resolution of the DAC can express X/2^{A} V per one bit as X V/A-bits.

In another example, the maximum gamma reference voltage GMAmax when sensing the updated threshold voltage may be lower than the maximum gamma reference voltage GMAmax in the event of the threshold voltage sensing operation and the driving operation. According to the aforementioned example, the sensing voltage resolution of the ADC can express Y/2^{A} V per one bit as Y V/A-bits.

When sensing and compensating for the initial threshold voltage of the sub-pixel of the OLED display device 100 according to the present embodiments, in the initializing operation ①, as described with reference to FIG. 13, the ADC can sense the saturated voltage Vg - Vth1 = Vdata1 - Vth1 of the second node N2 of the drive transistor DRT in units of Y/2^{A} V.

The timing controller 140 may calculate the initial threshold voltage Vth1, and store the calculated result in the memory 1360 as the data compensation amount ΔData. The timing controller 140 may calculate the data compensation amount ΔData (Vth1) using the threshold voltage Vth1 of each of the sub-pixels in units of Z V/A bits = Z/2^{A} V/bit as in Table 2.

In the sub-pixel compensating operation ③, when arriving at timing to drive the sub-pixels arrives, the timing controller 140 converts the data compensation amount ΔData (Vth1) stored in the memory 1360 to be harmonious with the output voltage resolution (X/2^{A} V/bit) of the DAC as in Table 8, and supplies the compensated data Data1' = Data1 + ΔData (Vth1) to the data driver 120.

**Table 8**

| Sensed Vth1 (V) | Value stored as ΔData(Bit) | Down-converted ΔData value(Bit) |
|---|---|---|
| Y/2^{A} | 1 | 1 |
| 2Y/2^{A} | 1 | 1 |
| 3Y/2^{A} | 2 | 1 |
| 4Y/2^{A} | 2 | 1 |
| 5Y/2^{A} | 3 | 1 |
| 6Y/2^{A} | 3 | 1 |

Similarly, when sensing the updated threshold voltage of the sub-pixel, in operation ④, the DAC applies the compensated data voltage Vdata2 = Vdata1 + Vth1 corresponding to the compensated data Data1' = Data1 + ΔData (Vth1) of the relevant sub-pixel to the first node N1 of the drive transistor DRT within the sub-pixel of interest. The data voltage Vdata is fixed as a V, and the data compensation amount ΔData (Vth1) converted to be harmonious with the output voltage resolution (Z/2^{A} V/bit) of the DAC is as in Table 9. Thus, the compensated data voltage Vdata2 = Vdata1 + Vth1 may be as in Table 9. Here, Z may be greater than Y. Hereinafter, it is assumed that Z = 2Y, but this is not intended to be limiting.

**Table 9**

| Sensed Vth1(V) | Value stored as ΔData(Bit) | Applied Voltage (V) (DAC output) |
|---|---|---|
| Y/2^{A} | 1 | a + (2Y/2^{A}) |
| 2Y/2^{A} | 1 | a + (2Y/2^{A}) |
| 3Y/2^{A} | 2 | a + (4Y/2^{A}) |
| 4Y/2^{A} | 2 | a + (4Y/2^{A}) |
| 5Y/2^{A} | 3 | a + (6Y/2^{A}) |
| 6Y/2^{A} | 3 | a + (6Y/2^{A}) |

In the threshold voltage variation sensing operation ⑥, the ADC senses the saturated voltage Vdata2 - ΔVth1 = Vdata1 + Vth1 - ΔVth1 of the second node N2 of the drive transistor DRT in units of Y/2^{A} V. The threshold voltage variation ΔVth1 according to the initial threshold voltage Vth1 is as in Table 10.

**Table 10**

| Previous Vth1 (V) | Sensed ΔVth1 (V) | ΔData update value(Bit) |
|---|---|---|
| Y/2^{A} | -Y/2^{A} | -1 |
| 2Y/2^{A} | 0 | 0 |
| 3Y/2^{A} | -Y/2^{A} | -1 |
| 4Y/2^{A} | 0 | 0 |
| 5Y/2^{A} | -Y/2^{A} | -1 |
| 6Y/2^{A} | 0 | 0 |

In the data compensation amount calculating operation ⑦, when calculating the data compensation amount ΔData (Vth1 + ΔVth) of each of the sub-pixels, the timing controller 140 calculates the data compensation amount ΔData (Vth1 + ΔVth1) using the previous data compensation amount ΔData (Vth1) and the threshold voltage variation ΔVth1, for instance, in units of Z V/A-bits = Z/2^{A} V/bit as in Table 11.

**Table 11**

| ΔVth1 (V) | ΔData update value(Bit) |
|---|---|
| -Y/2^{A} | - |
| 0 | 0 |
| -Y/2^{A} | - |
| 0 | 0 |
| -Y/2^{A} | - |
| 0 | 0 |

The timing controller 140 calculates the final data compensation amount ΔData (Vth1 + ΔVth1) of each of the sub-pixels using the threshold voltage variation ΔVth1 of each of the relevant sub-pixels and the initial threshold voltage Vth1, and store the calculated result in the memory 1360.

**Table 12**

| Initial Vth1 (V) | Sensed ΔVth1 (V) | Updated Vth2 (V) | Value stored as ΔData(Bit) |
|---|---|---|---|
| Y/2^{A} | -Y/2^{A} | 0 | 0 |
| 2Y/2^{A} | 0 | 2Y/2^{A} | 1 |
| 3Y/2^{A} | -Y/2^{A} | 2Y/2^{A} | 1 |
| 4Y/2^{A} | 0 | 4Y/2^{A} | 2 |
| 5Y/2^{A} | -Y/2^{A} | 4Y/2^{A} | 2 |
| 6Y/2^{A} | 0 | 6Y/2^{A} | 3 |

FIG. 18 is a graph illustrating an improvement in the sensed voltage error of the threshold voltage according to changes in the gamma reference voltage applied to the data driver when sensing the threshold voltage.

Referring to FIG. 18, when sensing the threshold voltage Vth1 and the threshold voltage variation ΔVth1 of the display device, the gamma reference voltage applied to the data driver can be reduced, and the DAC can express, as illustrated in FIG. 17, the A-bit data as Vc/A-bits in the event of the initial threshold voltage sensing operation and the driving operation, but as (Vb-Va)/A-bits when updating the threshold voltage. Thus, updating the threshold voltage, the output voltage resolution of the DAC can be increased. Thereby, the output data voltage applied to the data driver 120 can be made more minute, and the threshold voltage Vth and the threshold voltage variation ΔVth can be more accurately sensed.

In the display device as set forth above, it is possible to sense the threshold voltage Vth1 and the changes ΔVth1 in the threshold voltage in more precise units in the operation of sensing an initial threshold voltage and an updated threshold voltage. It is therefore possible to more completely compensate for the threshold voltage Vth, whereby no stains form on the screen having low-grayscale luminance.

The foregoing descriptions and the accompanying drawings have been presented in order to explain the certain principles of the present invention. A person skilled in the art to which the invention relates can make many modifications and variations by combining, dividing, substituting for, or changing the elements without departing from the principle of the invention. The foregoing embodiments disclosed herein shall be interpreted as illustrative only but not as limitative of the principle and scope of the invention. It should be understood that the scope of the invention shall be defined by the appended Claims.

## Claims

1. An organic light-emitting diode display device comprising:
an organic light-emitting diode display panel (110) on which subpixels (SP) are disposed;
a gamma reference voltage supply circuit (1350) adapted to supply gamma reference voltages (GMAmax-GMAmin) and to vary the gamma reference voltages supplied during a sensing operation for sensing a threshold voltage in respect to the gamma reference voltages supplied during a driving operation; a data driver (120) adapted to supply data voltages (Vdata) based on the gamma reference voltages to data lines (DL),
wherein the data driver (120) is adapted to sense a voltage (Vsen) of a sensing node (N2) within each of the subpixels (SP) in the sensing operation; and
a timing controller (140) adapted to control the data driver (120), wherein the timing controller (120) is adapted to perform a compensation process based on the voltage (VSen) sensed by the data driver (120),
wherein the gamma reference voltage supply circuit (1350) is adapted to supply gamma reference voltages (GMAmax-GMAmin) having a first voltage range during the driving operation and the gamma reference voltage supply circuit (1350) is adapted to supply gamma reference voltages (GMAmax-GMAmin) having a second voltage range during the sensing operation for sensing the threshold voltage (Vth) of the sensing node (N2), wherein the first voltage range is greater than the second voltage range;
**characterized in that**: the sensing operation for sensing the threshold voltage includes an initial threshold voltage sensing operation and an updating operation of sensing a change of the initial threshold voltage, and the gamma reference voltage supply circuit is adapted to supply gamma reference voltages (GMAmax-GMAmin) having a greater voltage range during the initial threshold voltage sensing operation than during the updating operation of the threshold voltage.

2. The organic light-emitting diode display device according to any one of the preceding claims, wherein the gamma reference voltage supply circuit (1350) is adapted to supply the gamma reference voltages within a predetermined gamma reference voltage range between a minimum gamma reference voltage (GMAmin) and a maximum gamma reference voltage (GMAmax), and is adapted to vary at least one of the minimum gamma reference voltage (GMAmin) and the maximum gamma reference voltage (GMAmax), thereby varying the gamma reference voltages.

3. The organic light-emitting diode display device according to any one of the preceding claims, wherein the data driver (120) includes a digital-to-analog converter (DAC) adapted to supply the data voltages based on the gamma reference voltages within the predetermined gamma reference voltage range to the data lines (DL).

4. The organic light-emitting diode display device according to claim 3, wherein the data driver (120) comprises an analog-to-digital converter (ADC) sensing a voltage (Vsen) of a sensing node (N2) within each of the subpixels (SP) in the sensing operation.

5. The organic light-emitting diode display device according to claim 4, wherein the digital-to-analog converter (DAC) is adapted to supply the data voltages (Vdata) based on the gamma reference voltages in the predetermined gamma reference voltage range, and is adapted to supply the data voltages based on the gamma reference voltages in a range narrower than the predetermined gamma reference voltage range to the data lines (DL) when the threshold voltage is updated.

6. The organic light-emitting diode display device according to claim 5, wherein the analog-to-digital converter (ADC) is adapted to sense a threshold voltage (Vth1) of a driving transistor (DRT) of each of the subpixels (SP) when sensing the initial threshold voltage, and is adapted to sense a change in the threshold voltage (ΔVth1) of the driving transistor (DRT) of each of the subpixels (SP) when the threshold voltage is updated.

7. The organic light-emitting diode display device according to any one of the preceding claim 6, further comprising a memory (760, 1360),
wherein the timing controller (140) is adapted to save the threshold voltage (Vth1) of the driving transistor (DRT) of each of the subpixels (SP) sensed by the analog-to-digital converter (ADC) in the memory (760, 1360) when sensing the initial threshold voltage, and is adapted to supply compensated data (Data') based on the threshold voltage to the data driver (120) during driving, and
wherein the timing controller (140) is adapted to save the change in the threshold voltage (ΔVth1) of the driving transistor (DRT) of each of the subpixels (SP) sensed by the analog-to-digital converter (ADC) in the memory (760, 1360) when sensing the change in the threshold voltage, and is adapted to supply compensated data based on the threshold voltage and the change in the threshold voltage during driving.

8. The organic light-emitting diode display device according to claim 7, wherein the timing controller is adapted to save the threshold voltage (Vth1) and the change in the threshold voltage (ΔVth1) sensed by the analog-to-digital converter (ADC) in the memory (1760, 1360) as a voltage per bit higher than a voltage per unit bit sensed by the analog-to-digital converter (ADC).

9. The organic light-emitting diode display device according to any one of the preceding claims 6-8, wherein the maximum gamma reference voltage (GMAmax) when sensing the updated threshold voltage (ΔVth1) is lower than the maximum gamma reference voltage (GMAmax) during the initial threshold voltage sensing operation and the driving operation.

10. The organic light-emitting diode display device according to any one of the preceding claims 6-9, wherein the minimum gamma reference voltage (GMAmin) when sensing the updated threshold voltage (ΔVth1) is higher than the minimum gamma reference voltage (GMAmin) during the initial threshold voltage sensing operation and the driving operation.

11. The organic light-emitting diode display device according to any one of the preceding claims, wherein each of the subpixels (SP) comprises:
an organic light-emitting diode (OLED);
a driving transistor (DRT) comprising a first node (N1) to which the data voltages (Vdata) are applied, a second node (N2) connected to a first electrode of the organic light-emitting diode (OLED), and a third node (N3) electrically connected to a driving voltage line (DVL);
a first transistor (T1) electrically connected between a corresponding data line (DL) of the data lines (DL) through which the data voltages (Vdata) are supplied and the first node (N1) of the driving transistor (DRT);
a second transistor (T2) electrically connected between a reference voltage line (RVL) through which a reference voltage (Vref) is supplied and a second node (N2) of the driving transistor (DRT); and
a capacitor (Cstg) electrically connected between the first node (N1) and the second node (N2) of the driving transistor (DRT).

12. The organic light-emitting diode display device according to any one of the preceding claims, further comprising a power controller (150) coupled to the data driver (120), wherein the gamma reference voltage supply circuit (1350) is included in the power controller (150) or in the data driver (120).

13. Method for operating an organic light-emitting diode display device according to claim 1, comprising the steps of:
providing the gamma reference voltages (GMAmax-GMAmin) having the first voltage range greater than the second voltage range during the driving operation of the organic light-emitting diode display device;
providing the gamma reference voltages (GMAmax-GMAmin) having the second voltage range during the sensing operation for sensing the threshold voltage; supplying the data voltages (Vdata) based on the gamma reference voltages to the data lines (DL),
sensing the voltage (Vsen) of the sensing node (N2) within each of the subpixels (SP) in the sensing operation; compensating data voltages to be supplied to the OLED display panel based on the sensed voltage;
**characterized in that** the sensing operation for sensing the threshold voltage includes the initial threshold voltage sensing operation and the updating operation of sensing a change of the initial threshold voltage;
the method being further **characterized by**:
providing gamma reference voltages (GMAmax-GMAmin) having a greater voltage range during the initial threshold voltage sensing operation than during the updating operation of the threshold voltage.

## Patentansprüche

1. Organische Leuchtdiodenanzeigevorrichtung, die Folgendes umfasst:
eine organische Leuchtdiodenanzeigetafel (110), auf der Unterpixel (SP) vorgesehen sind;
eine Gammabezugsspannungsspeiseschaltung (1350), die dafür ausgelegt ist, Gammabezugsspannungen (GMAmax-GMAmin) einzuspeisen und die Gammabezugsspannungen zu variieren, die während eines Erfassungsvorgangs zum Erfassen einer Schwellenwertspannung in Bezug auf die Gammabezugsspannungen eingespeist werden, die während eines Ansteuervorgangs eingespeist werden;
einen Datentreiber (120), der dafür ausgelegt ist, Datenspannungen (Vdata) auf der Grundlage der Gammabezugsspannungen in Datenleitungen (DL) einzuspeisen,
wobei der Datentreiber (120) dafür ausgelegt ist, eine Spannung (Vsen) eines Erfassungsknotens (N2) innerhalb von jedem der Unterpixel (SP) in dem Erfassungsvorgang zu erfassen, und
eine Zeitvorgabensteuereinheit (140), die dafür ausgelegt ist, den Datentreiber (120) zu steuern, wobei die Zeitvorgabensteuereinheit (120) dafür ausgelegt ist, einen Ausgleichsprozess auf der Grundlage der Spannung (VSen), die durch den Datentreiber (120) erfasst wird, durchzuführen,
wobei die Gammabezugsspannungsspeiseschaltung (1350) dafür ausgelegt ist, Gammabezugsspannungen (GMAmax-GMAmin), die einen ersten Spannungsbereich aufweisen, während des Ansteuervorgangs einzuspeisen, und die Gammabezugsspannungsspeiseschaltung (1350) dafür ausgelegt ist, Gammabezugsspannungen (GMAmax-GMAmin), die einen zweiten Spannungsbereich aufweisen, während des Erfassungsvorgangs zum Erfassen der Schwellenwertspannung (Vth) des Erfassungsknotens (N2) einzuspeisen,
wobei der erste Spannungsbereich größer als der zweite Spannungsbereich ist;
**dadurch gekennzeichnet, dass**: der Erfassungsvorgang zum Erfassen der Schwellenwertspannung einen Erfassungsvorgang der Anfangsschwellenwertspannung und einen Aktualisierungsvorgang zum Erfassen einer Änderung der Anfangsschwellenwertspannung umfasst und die Gammabezugsspannungsspeiseschaltung dafür ausgelegt ist, Gammabezugsspannungen (GMAmax-GMAmin) einzuspeisen, die einen größeren Spannungsbereich während des Erfassungsvorgangs der Anfangsschwellenwertspannung als während des Aktualisierungsvorgangs der Schwellenwertspannung aufweisen.

2. Organische Leuchtdiodenanzeigevorrichtung nach einem der vorhergehenden Ansprüche, wobei die Gammabezugsspannungsspeiseschaltung (1350) dafür ausgelegt ist, die Gammabezugsspannungen innerhalb eines vorgegebenen Gammabezugsspannungsbereichs zwischen einer minimalen Gammabezugsspannung (GMAmin) und einer maximalen Gammabezugsspannung (GMAmax) einzuspeisen, und dafür ausgelegt ist, die minimale Gammabezugsspannung (GMAmin) und/oder die maximale Gammabezugsspannung (GMAmax) zu variieren, wodurch die Gammabezugsspannungen variiert werden.

3. Organische Leuchtdiodenanzeigevorrichtung nach einem der vorhergehenden Ansprüche, wobei der Datentreiber (120) einen Digital-Analog-Umsetzer (DAC) enthält, der dafür ausgelegt ist, die Datenspannungen auf der Grundlage der Gammabezugsspannungen innerhalb des vorgegebenen Gammabezugsspannungsbereichs in die Datenleitungen (DL) einzuspeisen.

4. Organische Leuchtdiodenanzeigevorrichtung nach Anspruch 3, wobei der Datentreiber (120) einen Analog-Digital-Umsetzer (ADC) umfasst, der eine Spannung (Vsen) eines Erfassungsknotens (N2) innerhalb von jedem der Unterpixel (SP) in dem Erfassungsvorgang erfasst.

5. Organische Leuchtdiodenanzeigevorrichtung nach Anspruch 4, wobei der Digital-Analog-Umsetzer (DAC) dafür ausgelegt ist, die Datenspannungen (Vdata) auf der Grundlage der Gammabezugsspannungen in dem vorgegebenen Gammabezugsspannungsbereich einzuspeisen, und dafür ausgelegt ist, die Datenspannungen auf der Grundlage der Gammabezugsspannungen in einem Bereich, der schmaler als der vorgegebene Gammabezugsspannungsbereich ist, in die Datenleitungen (DL) einzuspeisen, wenn die Schwellenwertspannung aktualisiert ist.

6. Organische Leuchtdiodenanzeigevorrichtung nach Anspruch 5, wobei der Analog-Digital-Umsetzer (ADC) dafür ausgelegt ist, eine Schwellenwertspannung (Vth1) eines Ansteuertransistors (DRT) von jedem der Unterpixel (SP) zu erfassen, wenn er die Anfangsschwellenwertspannung erfasst, und dafür ausgelegt ist, eine Änderung der Schwellenwertspannung (ΔVth1) des Ansteuertransistors (DRT) von jedem der Unterpixel (SP) zu erfassen, wenn die Schwellenwertspannung aktualisiert ist.

7. Organische Leuchtdiodenanzeigevorrichtung nach Anspruch 6, die ferner einen Speicher (760, 1360) umfasst,
wobei die Zeitvorgabensteuereinheit (140) dafür ausgelegt ist, die Schwellenwertspannung (Vth1) des Ansteuertransistors (DRT) von jedem der Unterpixel (SP), die durch den Analog-Digital-Umsetzer (ADC) erfasst wird, in dem Speicher (760, 1360) zu speichern, wenn die Anfangsschwellenwertspannung erfasst wird, und dafür ausgelegt ist, kompensierte Daten (Data') auf der Grundlage der Schwellenwertspannung in den Datentreiber (120) während des Ansteuerns einzuspeisen, und
wobei die Zeitvorgabensteuereinheit (140) dafür ausgelegt ist, die Änderung der Schwellenwertspannung (ΔVth1) des Ansteuertransistors (DRT) von jedem der Unterpixel (SP), die durch den Analog-Digital-Umsetzer (ADC) erfasst wird, in dem Speicher (760, 1360) zu speichern, wenn die Änderung der Schwellenwertspannung erfasst wird, und dafür ausgelegt ist, kompensierte Daten auf der Grundlage der Schwellenwertspannung und der Änderung der Schwellenwertspannung während des Ansteuerns einzuspeisen.

8. Organische Leuchtdiodenanzeigevorrichtung nach Anspruch 7, wobei die Zeitvorgabensteuereinheit dafür ausgelegt ist, die Schwellenwertspannung (Vth1) und die Änderung der Schwellenwertspannung (ΔVth1), die durch den Analog-Digital-Umsetzer (ADC) erfasst wird, als eine Spannung pro Bit, die höher als eine Spannung pro Einheitsbit ist, die durch den Analog-Digital-Umsetzer (ADC) erfasst wird, in dem Speicher (1760, 1360) zu speichern.

9. Organische Leuchtdiodenanzeigevorrichtung nach einem der Ansprüche 6-8, wobei die maximale Gammabezugsspannung (GMAmax) dann, wenn die aktualisierte Schwellenwertspannung (ΔVth1) erfasst wird, niedriger als die maximale Gammabezugsspannung (GMAmax) während des Erfassungsvorgangs der Anfangsschwellenwertspannung und des Ansteuervorgangs ist.

10. Organische Leuchtdiodenanzeigevorrichtung nach einem der Ansprüche 6-9, wobei die minimale Gammabezugsspannung (GMAmin) dann, wenn die aktualisierte Schwellenwertspannung (ΔVth1) erfasst wird, höher als die minimale Gammabezugsspannung (GMAmin) während des Erfassungsvorgangs der Anfangsschwellenwertspannung und des Ansteuervorgangs ist.

11. Organische Leuchtdiodenanzeigevorrichtung nach einem der vorhergehenden Ansprüche, wobei jedes der Unterpixel (SP) Folgendes umfasst:
eine organische Leuchtdiode (OLED);
einen Ansteuertransistor (DRT), der einen ersten Knoten (N1), an den Datenspannungen (Vdata) angelegt werden, einen zweiten Knoten (N2), der mit einer ersten Elektrode der organischen Leuchtdiode (OLED) verbunden ist, und einen dritten Knoten (N3), der mit einer Ansteuerspannungsleitung (DVL) elektrisch verbunden ist, umfasst;
einen ersten Transistor (T1), der zwischen eine entsprechende Datenleitung (DL) der Datenleitungen (DL), durch die die Datenspannungen (Vdata) eingespeist werden, und den ersten Knoten (N1) des Ansteuertransistors (DRT) elektrisch geschaltet ist;
einen zweiten Transistor (T2), der zwischen eine Bezugsspannungsleitung (RVL), durch die eine Bezugsspannung (Vref) eingespeist wird, und einen zweiten Knoten (N2) des Ansteuertransistors (DRT) elektrisch geschaltet ist, und
einen Kondensator (Cstg), der zwischen den ersten Knoten (N1) und den zweiten Knoten (N2) des Ansteuertransistors (DRT) elektrisch geschaltet ist.

12. Organische Leuchtdiodenanzeigevorrichtung nach einem der vorhergehenden Ansprüche, die ferner eine Leistungssteuereinheit (150) umfasst, die an den Datentreiber (120) gekoppelt ist, wobei die Gammabezugsspannungsspeiseschaltung (1350) in der Leistungssteuereinheit (150) oder in dem Datentreiber (120) enthalten ist.

13. Verfahren zum Betreiben einer organischen Leuchtdiodenanzeigevorrichtung nach Anspruch 1, das die folgenden Schritte umfasst:
Bereitstellen der Gammabezugsspannungen (GMAmax-GMAmin), die den ersten Spannungsbereich aufweisen, der größer als der zweite Spannungsbereich ist, während des Ansteuervorgangs der organischen Leuchtdiodenanzeigevorrichtung;
Bereitstellen der Gammabezugsspannungen (GMAmax-GMAmin), die den zweiten Spannungsbereich aufweisen, während des Erfassungsvorgangs zum Erfassen der Schwellenwertspannung;
Einspeisen der Datenspannungen (Vdata) auf der Grundlage der Gammabezugsspannungen in die Datenleitungen (DL),
Erfassen der Spannung (Vsen) des Erfassungsknotens (N2) innerhalb von jedem der Unterpixel (SP) in dem Erfassungsvorgang;
Kompensieren von Datenspannungen, die in die OLED-Anzeigetafel eingespeist werden, auf der Grundlage der erfassten Spannung;
**dadurch gekennzeichnet, dass** der Erfassungsvorgang zum Erfassen der Schwellenwertspannung einen Erfassungsvorgang der Anfangsschwellenwertspannung und einen Aktualisierungsvorgang zum Erfassen einer Änderung der Anfangsschwellenwertspannung umfasst; wobei das Verfahren ferner **gekennzeichnet ist durch**:
Bereitstellen von Gammabezugsspannungen (GMAmax-GMAmin), die einen größeren Spannungsbereich während des Erfassungsvorgangs der Anfangsschwellenwertspannung als während des Aktualisierungsvorgangs der Schwellenwertspannung aufweisen.

## Revendications

1. Dispositif d'affichage à diodes électroluminescentes organiques comprenant :
un panneau d'affichage à diodes électroluminescentes organiques (110) sur lequel des sous-pixels (SP) sont disposés ;
un circuit d'alimentation de tension de référence gamma (1350) apte à fournir des tensions de référence gamma (GMAmax-GMAmin) et à faire varier les tensions de référence gamma fournies au cours d'une opération de détection pour détecter une tension de seuil par rapport aux tensions de référence gamma fournies au cours d'une opération d'attaque ;
un circuit d'attaque de données (120) apte à fournir des tensions de données (Vdata) sur la base des tensions de référence gamma à des lignes de données (DL),
dans lequel le circuit d'attaque de données (120) est apte à détecter une tension (Vsen) d'un noeud de détection (N2) à l'intérieur de chacun des sous-pixels (SP) à l'opération de détection ; et
un organe de commande de timing (140) apte à commander le circuit d'attaque de données (120), dans lequel l'organe de commande de timing (120) est apte à effectuer un processus de compensation sur la base de la tension (VSen) détectée par le circuit d'attaque de données (120),
dans lequel le circuit d'alimentation de tension de référence gamma (1350) est apte à fournir des tensions de référence gamma (GMAmax-GMAmin) ayant une première plage de tensions au cours de l'opération d'attaque et le circuit d'alimentation de tension de référence gamma (1350) est apte à fournir des tensions de référence gamma (GMAmax-GMAmin) ayant une deuxième plage de tensions au cours de l'opération de détection pour détecter la tension de seuil (Vth) du noeud de détection (N2),
dans lequel la première plage de tensions est supérieure à la deuxième plage de tensions ;
**caractérisé en ce que** :
l'opération de détection pour détecter la tension de seuil comprend une opération de détection de tension de seuil initiale et une opération de mise à jour de détection d'un changement de la tension de seuil initiale, et
le circuit d'alimentation de tension de référence gamma est apte à fournir des tensions de référence gamma (GMAmax-GMAmin) ayant une plage de tensions supérieure au cours de l'opération de détection de tension de seuil initiale à celle au cours de l'opération de mise à jour de la tension de seuil.

2. Dispositif d'affichage à diodes électroluminescentes organiques selon la revendication 1, dans lequel le circuit d'alimentation de tension de référence gamma (1350) est apte à fournir les tensions de référence gamma à l'intérieur d'une plage de tensions de référence gamma prédéterminée entre une tension de référence gamma minimale (GMAmin) et une tension de référence gamma maximale (GMAmax), et est apte à faire varier au moins l'une de la tension de référence gamma minimale (GMAmin) et de la tension de référence gamma maximale (GMAmax), en faisant varier de ce fait les tensions de référence gamma.

3. Dispositif d'affichage à diodes électroluminescentes organiques selon l'une quelconque des revendications précédentes, dans lequel le circuit d'attaque de données (120) comprend un convertisseur numérique-analogique (DAC) apte à fournir les tensions de données sur la base des tensions de référence gamma à l'intérieur de la plage de tensions de référence gamma prédéterminée aux lignes de données (DL).

4. Dispositif d'affichage à diodes électroluminescentes organiques selon la revendication 3, dans lequel le circuit d'attaque de données (120) comprend un convertisseur analogique-numérique (ADC) détectant une tension (Vsen) d'un noeud de détection (N2) à l'intérieur de chacun des sous-pixels (SP) à l'opération de détection.

5. Dispositif d'affichage à diodes électroluminescentes organiques selon la revendication 4, dans lequel le convertisseur numérique-analogique (DAC) est apte à fournir les tensions de données (Vdata) sur la base des tensions de référence gamma dans la plage de tensions de référence gamma prédéterminée, et est apte à fournir les tensions de données sur la base des tensions de référence gamma dans une plage plus étroite que la plage de tensions de référence gamma prédéterminée aux lignes de données (DL) lorsque la tension de seuil est mise à jour.

6. Dispositif d'affichage à diodes électroluminescentes organiques selon la revendication 5, dans lequel le convertisseur analogique-numérique (ADC) est apte à détecter une tension de seuil (Vth1) d'un transistor d'attaque (DRT) de chacun des sous-pixels (SP) lors de la détection de la tension de seuil initiale, et est apte à détecter un changement de la tension de seuil (ΔVth1) du transistor d'attaque (DRT) de chacun des sous-pixels (SP) lorsque la tension de seuil est mise à jour.

7. Dispositif d'affichage à diodes électroluminescentes organiques selon la revendication 6, comprenant en outre une mémoire (760, 1360),
dans lequel l'organe de commande de timing (140) est apte à enregistrer la tension de seuil (Vth1) du transistor d'attaque (DRT) de chacun des sous-pixels (SP) détectée par le convertisseur analogique-numérique (ADC) dans la mémoire (760, 1360) lors de la détection de la tension de seuil initiale, et est apte à fournir des données compensées (Data') sur la base de la tension de seuil au circuit d'attaque de données (120) au cours de l'attaque, et
dans lequel l'organe de commande de timing (140) est apte à enregistrer le changement de la tension de seuil (ΔVth1) du transistor d'attaque (DRT) de chacun des sous-pixels (SP) détectée par le convertisseur analogique-numérique (ADC) dans la mémoire (760, 1360) lors de la détection du changement de la tension de seuil, et est apte à fournir des données compensées sur la base de la tension de seuil et du changement de la tension de seuil au cours de l'attaque.

8. Dispositif d'affichage à diodes électroluminescentes organiques selon la revendication 7, dans lequel l'organe de commande de timing est apte à enregistrer la tension de seuil (Vth1) et le changement de la tension de seuil (ΔVth1) détectée par le convertisseur analogique-numérique (ADC) dans la mémoire (1760, 1360) en tant qu'une tension par bit supérieure à une tension par bit unitaire détectée par le convertisseur analogique-numérique (ADC).

9. Dispositif d'affichage à diodes électroluminescentes organiques selon l'une quelconque des revendications 6 à 8,
dans lequel la tension de référence gamma maximale (GMAmax) lors de la détection de la tension de seuil mise à jour (ΔVth1) est inférieure à la tension de référence gamma maximale (GMAmax) au cours de l'opération de détection de tension de seuil initiale et de l'opération d'attaque.

10. Dispositif d'affichage à diodes électroluminescentes organiques selon l'une quelconque des revendications 6 à 9,
dans lequel la tension de référence gamma minimale (GMAmin) lors de la détection de la tension de seuil mise à jour (ΔVth1) est supérieure à la tension de référence gamma minimale (GMAmin) au cours de l'opération de détection de tension de seuil initiale et de l'opération d'attaque.

11. Dispositif d'affichage à diodes électroluminescentes organiques selon l'une quelconque des revendications précédentes, dans lequel chacun des sous-pixels (SP) comprend :
une diode électroluminescente organique (OLED) ;
un transistor d'attaque (DRT) comprenant un premier noeud (N1) auquel les tensions de données (Vdata) sont appliquées, un deuxième noeud (N2) raccordé à une première électrode de la diode électroluminescente organique (OLED), et un troisième noeud (N3) électriquement raccordé à une ligne de tension d'attaque (DVL) ;
un premier transistor (T1) électriquement raccordé entre une ligne de données correspondante (DL) des lignes de données (DL) par l'intermédiaire de laquelle les tensions de données (Vdata) sont fournies et le premier noeud (N1) du transistor d'attaque (DRT) ;
un deuxième transistor (T2) électriquement raccordé entre une ligne de tension de référence (RVL) par l'intermédiaire de laquelle une tension de référence (Vref) est fournie et un deuxième noeud (N2) du transistor d'attaque (DRT) ; et
un condensateur (Cstg) électriquement raccordé entre le premier noeud (N1) et le deuxième noeud (N2) du transistor d'attaque (DRT).

12. Dispositif d'affichage à diodes électroluminescentes organiques selon l'une quelconque des revendications précédentes, comprenant en outre un organe de commande de puissance (150) couplé au circuit d'attaque de données (120), dans lequel le circuit d'alimentation de tension de référence gamma (1350) est inclus dans l'organe de commande de puissance (150) ou dans le circuit d'attaque de données (120).

13. Procédé de fonctionnement d'un dispositif d'affichage à diodes électroluminescentes organiques selon la revendication 1, comprenant les étapes suivantes :
fournir les tensions de référence gamma (GMAmax-GMAmin) ayant la première plage de tensions supérieure à la deuxième plage de tensions au cours de l'opération d'attaque du dispositif d'affichage à diodes électroluminescentes organiques ;
fournir les tensions de référence gamma (GMAmax-GMAmin) ayant la deuxième plage de tensions au cours de l'opération de détection pour détecter la tension de seuil ;
fournir les tensions de données (Vdata) sur la base des tensions de référence gamma aux lignes de données (DL),
détecter la tension (Vsen) du noeud de détection (N2) à l'intérieur de chacun des sous-pixels (SP) à l'opération de détection ;
compenser des tensions de données à fournir au panneau d'affichage OLED sur la base de la tension détectée ;
**caractérisé en ce que** l'opération de détection pour détecter la tension de seuil comprend l'opération de détection de tension de seuil initiale et l'opération de mise à jour de détection d'un changement de la tension de seuil initiale ;
le procédé étant en outre **caractérisé par** :
la fourniture de tensions de référence gamma (GMAmax-GMAmin) ayant une plage de tensions supérieure au cours de l'opération de détection de tension de seuil initiale à celle au cours de l'opération de mise à jour de la tension de seuil.
